# EUROPEAN PATENT SPECIFICATION

(11) **EP 4 580 211 B1**
(45) Date of publication and mention of the grant of the patent: **14.10.2026**
(21) Application number: 25176643.2
(22) Date of filing: 26.07.2016
(51) Int. Cl.: G02F 1/133, H04R 1/02, G02F 1/1333, H04R 5/02, H04R 9/04, H04R 9/06, H04R 7/04

(54) **PANEL VIBRATION TYPE SOUND GENERATING DISPLAY DEVICE**
SCHALLERZEUGENDE ANZEIGEVORRICHTUNG VOM PLATTENVIBRATIONSTYP
DISPOSITIF D'AFFICHAGE GÉNÉRANT UN SON DU TYPE À VIBRATION DE PANNEAU

(30) Priority: 28.03.2016 KR 20160037118
(43) Date of publication of application: 02.07.2025
(62) Document number(s) of the earlier application(s) in accordance with Art. 76 EPC: 19168786.2 / 3 534 206; 16181185.6 / 3 226 069
(73) Proprietor: LG Display Co., Ltd., Seoul 150-721 (KR)
(72) Inventor: CHOI, Yeong Rak, 03727 Seoul (KR); OH, Chang Ho, 137-804 Seoul (KR); PARK, Kwan Ho, 413-902 Gyeonggi-do (KR); LEE, Sungtae, 21341 Incheon (KR)
(74) Representative: Cousens, Nico

(56) References cited:
- EP-A2- 1 507 438
- EP-A2- 2 947 857
- JP-A- 2009 100 223
- US-A1- 2006 140 439
- US-A1- 2012 243 719
- US-B2- 9 137 592

## Description

### CROSS REFERENCE TO RELATED APPLICATION

This application claims priority from Korean Patent Application No. 10-2016-0037118, filed on March 28, 2016.

### BACKGROUND OF THE INVENTION

### 1. Field of the invention

The present disclosure relates to a display device and, more specifically, to a display device for generating sound by directly vibrating a display panel thereof.

### 2. Description of the Prior Art

With the development of various portable electronic devices, such as a mobile communication terminal and a notebook computer, a requirement for a flat panel display device applicable thereto is increasing.

The flat panel display devices, which are being researched, include a Liquid Crystal Display Device, a Plasma Display Panel, a Field Emission Display Device, a Light Emitting Diode Display Device, and an Organic Light Emitting Diode Display Device.

Among these display devices, the Liquid Crystal Display (LCD) device includes: an array substrate including a thin film transistor; an upper substrate including a color filter and/or a black matrix, etc.; and a liquid crystal material layer formed therebetween, wherein an alignment state of the liquid crystal layer is controlled according to an electric field applied between opposite electrodes of a pixel area, and thereby the transmittance of light is adjusted to display an image.

In a display panel of such a liquid crystal display device, an Active Area (AA) configured to provide an image to a user and a Non-active Area (NA), which is a peripheral area of the Active Area (AA), are defined. The display panel is usually manufactured by attaching a first substrate, which is an array substrate having a thin film transistor formed therein to define a pixel area, and a second substrate, which is an upper substrate having a black matrix and/or color filter layer formed thereon, to each other.

The array substrate or first substrate, on which a thin film transistor is formed, includes a plurality of gate lines GS extending in a first direction and a plurality of data lines DL extending in a second direction perpendicular to the first direction, and one pixel area P is defined by each gate line and each data line. One or more thin film transistors are formed in one pixel area P, and gate and source electrodes of each thin film transistor may be connected to a gate line and a data line, respectively.

Among these display devices, the liquid crystal display device does not have its own light-emitting element and thus needs a separate light source. Therefore, the liquid crystal display device has a back-light unit having a light source, such as an LED, which is arranged at the rear surface thereof and irradiates a light toward a front surface of the liquid crystal panel thereof, thereby at last implementing a recognizable image.

Meanwhile, an Organic Light Emitting Diode (OLED) display device recently coming into the spotlight as a display device has advantages of a fast response rate, a high light emitting efficiency, a high luminance and a wide viewing angle because of using an OLED which emits light by itself.

In the organic light emitting diode display device, sub-pixels including organic light emitting diodes are arranged in a matrix form, and the brightness of sub-pixels selected by a scan signal is controlled according to a gray scale of data. Further, the organic light emitting diode display device, which is an emissive element, consumes small power and has a high response speed, a high light emitting efficiency, a high luminance, and a wide viewing angle.

Meanwhile, a set apparatus or finished product including such a display device as described above may include, for example, a television (TV), a computer monitor, and an advertising panel.

Such a display device or set apparatus includes a sound output device, such as a speaker, for generating and outputting sound relating to an image.

It is normal that a company which manufactures a display device, such as a liquid crystal display device or an organic light emitting diode display device, manufactures only a display panel or display device, while another company which manufactures a speaker assembles the speaker with the manufactured display device, so as to finally complete a set apparatus capable of outputting an image and sound.

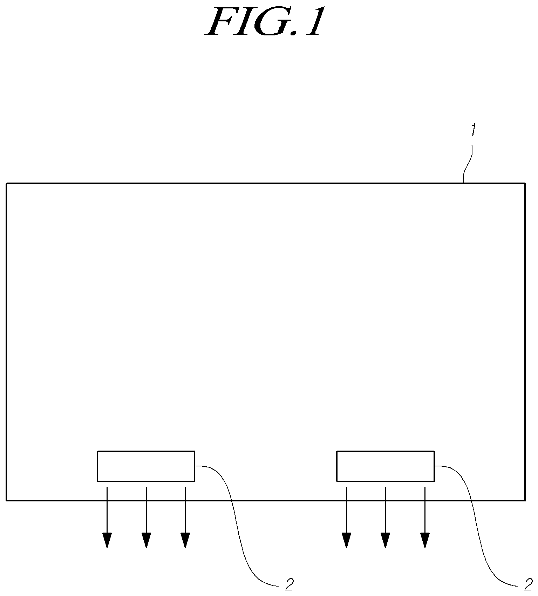

FIG. 1 is a schematic plan view of a speaker included in a conventional display device.

As shown in FIG. 1, the conventional display device 1 includes a speaker 2 disposed at a rear or lower part of a display panel thereof.

In this structure, the sound generated by the speaker 2 does not progress toward a viewer, who is viewing an image from the front side of the display device 1, but progresses toward the rear side or the underside of the display panel rather than the display panel on which the image is being displayed. Therefore, the sound may disturb the viewer's immersion.

Further, when the sound generated from the speaker 2 progresses toward the rear side or underside of the display panel, the sound quality may be degraded due to an interference with sound reflected by a wall or floor.

Also, the sound generated by a speaker included in the conventional display device is not oriented toward a viewer of the display device and may thus undergo diffraction, which degrades the sound localization. Moreover, in configuring a set apparatus, such as a TV, a speaker may occupy a predetermined space, which imposes a restriction on the design and spatial disposition of the set apparatus.

Therefore, there has been an increasing requirement for a technology which can improve the quality of sound output from a display device and prevent the viewer's immersion from being disturbed.

US 9 137 592 B2 in its abstract states "An apparatus including a frame; and a speaker connected to the frame. The speaker includes at least one vibrating element and least one display element. The least one vibrating element is configured to at least partially move the at least one display element generate sound waves from the at least one display element. A connection of the speaker to the frame includes a first section at a first location of the at least one display element and a second section at a second location of the at least one display element. The first section includes a soft suspension of the at least one display element between the at least one display element and the frame. The second section includes a harder suspension of the at least one display element between the at least one display element and the frame than the first section. The at least one vibrating element is located away from the second location of the at least one display element and located proximate the at least one display element at the first location of the at least one display element so as to move the at least one display element substantially using the first section based on the soft suspension of the at least one display element."

US 2012/243719 A1 in its abstract states "Electronic devices that contain flexible displays and one or more display-based speaker structures may be provided. The speaker structures may be positioned under the flexible display. Portions of the flexible display may be used as speaker membranes for the speaker structures. The speaker structures may be driven by transducers that convert electrical audio signal input into sound. Piezoelectric transducers or transducers formed from coils and magnets may be used to drive the speaker structures. Speaker membranes may be formed from active display areas of the flexible display. Some, all, or substantially all of the flexible display may be used as a speaker membrane for one or more display-based speaker structures. An optional cover layer may be provided with speaker openings so that sound may pass from the display-based speaker structures to the exterior of the device." EP 1 507 438 A2 in its abstract states "The present invention is directed to a sound reproduction device which includes an LCD (20), which is an exemplary front panel, a case (22), and an electromechanical acoustic transducer (23). TheLCD (20) isoperabletoperformapredeterminedoperation in response to an electrical signal applied thereto. A space (24) for sound emission is formed between the case (22) and the LCD (20). The electromechanical acoustic transducer (23) is connected to the case (22), and emits sound to the space (24). If the electromechanical acoustic transducer (23) emits the sound to the space (24), energy of the emitted sound causes the LCD (20) to vibrate and thereby to externally output the sound."

JP 2009 100223 A in its abstract states "PROBLEM TO BE SOLVED: To provide an organic EL panel speaker that achieves an reliable attachment of an oscillating actuator to an organic EL panel, and that improves characteristics of sound oscillation. SOLUTION: An organic electro-luminescent panel speaker 1 has an organic electro-luminescent panel 3 and an oscillating actuator 41, wherein the oscillating actuator 41 is attached to a substrate 8 composing part of the organic electro-luminescent panel 3." (machine translation)

EP 2 947 857 A2 in its abstract states "A display apparatus (100) includes a display panel (110) which displays an image and a vibration member (300) attached to a surface (S2) of the display panel (110), where the vibration member (300) receives a sound signal, generates a vibration in response to the sound signal, and transfers the vibration to the display panel (110) to allow the display panel (110) to output a sound."

US 2006/140439 A1 in its abstract states "A method of mounting a flat panel speaker is provided which is capable of reliably preventing entry of dust and of shortening assembling time. By bonding a gasket member to a diaphragm, by pasting a separator to a gasket member side opposite to the diaphragm and, by sandwiching the diaphragm and the gasket member from both sides, a gasket-attached diaphragm is fabricated. After peeling off a protecting sheet on a rear side of the gasket-attached diaphragm, the actuator module is bonded to the diaphragm. Then, after peeling the separator from the gasket-attached diaphragm, positioning is performed on the diaphragm and the gasket member is bonded to a putting-face of the front case. The entry of dust into a region corresponding to a liquid crystal display panel is blocked by a partitioning portion of the gasket member."

### SUMMARY OF THE INVENTION

The presently claimed invention is defined in the independent claim.

The present disclosure has been made to overcome the above-mentioned problems of the prior art and, in one aspect, is to provide a panel vibration type sound generating display device, which can generate sound by directly vibrating a display panel configuring the display device.

In another aspect, the present disclosure is to provide a display device including a panel vibration type sound generating apparatus, which has a predetermined air gap formed between a display panel and a sound generating actuator and an actuator support hole formed in a support structure of the display device, so that the display device has a reduced thickness while having an excellent sound generation performance. The support structure may also be termed a support member or support part.

In another aspect, the present disclosure is to provide a display device having a sound generation baffle part formed therein, which includes an adhesive member (double-sided tape) attached between the upper surface of the support structure and the lower surface of the display panel and a sealing part disposed outside the adhesive member, so that the display device has an improved sound output characteristic.

In another aspect, the present disclosure is to provide a display device, which includes one or more buffer members arranged between the inner surface of the support structure and the rear surface of the display panel adjacent to a source PCB or between the support structure disposed at the rear surface of the display panel and the source PCB, in order to prevent interference and noise between the support structure and a Source PCB (S-PCB) for driving the display panel.

In another aspect, the present disclosure is to provide a display device in which a sound generating actuator is placed at a first position of a support structure of the display device and a set PCB of a set apparatus is placed at a second position different from the first position, so as to avoid interference between the sound generating actuator and the set PCB.

In still another aspect, the present disclosure is to provide a display device, which has a reinforcement member arranged inside the support structure of the display device when two or more sound generating actuators are used, so that the display device can prevent deformation of the support structure due to different vibration characteristics of the two or more sound generating actuators.

In view of the above aspects, a display device of the present embodiment includes: a display panel configured to display an image; and a sound generating actuator connected to a surface of the display panel configured to vibrate the display panel to generate sound. The surface may be an inner surface, for example.

The display device further includes a support structure comprising a cover bottom, configured to cover and support at least a rear surface of the display panel, wherein the sound generating actuator is inserted in and fixed to a support hole formed at the cover bottom.

The sound generating actuator may include: a plate inserted in the support hole; a magnet disposed on the plate; a center pole disposed at a center of the plate; a bobbin disposed to surround the center pole and be in contact with the display panel; and a coil wound around the bobbin. The plate may be a lower plate, for example.

The lower plate configuring the sound generating actuator further includes an extension part extending outward, and the extension part may be fixed to the lower surface of the cover bottom through a bolt, a PEM^{™} nut, or an adhesive member.

An air gap is formed between the display panel and the cover bottom, and the display device further includes a baffle part which may include an adhesive member and a sealing part arranged between the lower surface of the display panel and the upper surface of the support member at an edge of the air gap.

The support member includes a cover bottom supporting a rear side of the display panel and a middle cabinet supporting the edge of the display panel, and the middle cabinet includes an area division member configured to separate a first area including a source PCB and a second area including a sound generating actuator.

A recessed part is formed on an upper surface of the cover bottom opposite to the source PCB placed on a rear surface of the display panel, and a first buffer member spaced a predetermined distance from the lower surface of the display panel may be disposed on the recessed part. The recessed part may be concave, for example.

The cover bottom may have a second buffer member disposed thereon, which is in contact with the lower surface of the display panel and the upper surfaces of the cover bottom while separating a first area covering the source PCB and a second area covering the sound generating actuator.

The sound generating actuator may include two or more actuators, which are symmetrically arranged and have different vibration characteristics, and the cover bottom may further have a reinforcement member disposed thereon, which passes through adjacent positions of the two or more actuators.

An embodiment of the present disclosure as described above provides a display device including a panel vibration type sound generating display device, which generates sound by directly vibrating a display panel, thereby making it unnecessary to install a separate speaker to the display device or a set apparatus including the display device.

Further, since the progressing direction of the sound coincides with the image output direction in the display device, the display device or the set apparatus can improve the sound localization or sound output characteristics, can achieve easy designing of the mechanism of the set apparatus, and has a reduced thickness thereof.

Further, the display device has a predetermined air gap formed between the display panel and the sound generating actuator, and the sound generating actuator inserted in and fixed to a support hole formed at a support structure of the display device. Therefore, the display device has an excellent sound generation performance while having a reduced thickness.

Further, the display device has a baffle part, which includes an adhesive member (double-sided tape) attached between the upper surface of the support structure and the lower surface of the display panel and a sealing part disposed outside the adhesive member, and thus can minimize the sound leakage and thus can improve the sound generating performance.

Further, the arrangement of one or more buffer members between a source PCB of the display panel and the support structure disposed at the rear surface of the display panel to fix/support the sound generating actuator or between the inner surface of the support structure and the rear surface of the display panel adjacent to the source PCB can prevent generation of interference and noise between the support structure of the display device and a source PCB (S-PCB) for driving the display panel.

Also, the arrangement of the sound generating actuator and the set PCB of the set apparatus at different positions in the display device can avoid interference between the sound generating actuator and the set PCB and improve the sound characteristics.

Also, the arrangement of a reinforcement member inside the support structure of the display device using two or more sound generating actuators can prevent deformation of the support structure due to different vibrations of the two or more sound generating actuators or sound distortion by the vibration of the support structure.

Disclosed herein is a panel vibration type sound generating display device comprising: a display panel to display an image; and a sound generating actuator connected to a surface of the display panel and configured to vibrate the display panel to generate sound.

The panel vibration type sound generating display device further comprises a support structure configured to cover and support at least a rear surface of the display panel, wherein the sound generating actuator is inserted in a support hole disposed at the support structure to be fixed to the support structure.

The sound generating actuator of the panel vibration type sound generating display device may further comprise: a lower plate inserted in the support hole; a magnet disposed on the lower plate; a center pole disposed at a center of the lower plate; a bobbin disposed to surround the center pole and be in contact with the display panel; and a coil wound around the bobbin.

The support structure of the panel vibration type sound generating display device comprises a cover bottom, the lower plate further including an extension part extending outward, and the extension part being fixed to a lower surface of the cover bottom.

The extension part and the cover bottom of the panel vibration type sound generating display device, may be fixedly coupled to each other by one of a bolt fastened through a through-hole provided through the extension part to a screw hole disposed at the cover bottom and an adhesive member disposed between the extension part and the cover bottom.

The panel vibration type sound generating display device further comprises a baffle part disposed between the support structure and the lower surface of the display panel to define an air gap, which is a space in which the display panel can be vibrated by the sound generating actuator.

The baffle part of the panel vibration type sound generating display device may comprise an adhesive member disposed at an edge of the air gap and attached to the lower surface of the display panel and the upper surface of the support structure, and a sealing part disposed outside the adhesive member.

The sealing part of the panel vibration type sound generating display device may have a thickness larger than the thickness of the adhesive member.

The support structure of the panel vibration type sound generating display device comprises a cover bottom, which supports a rear side of the display panel, and a middle cabinet, which has a shape of a frame, coupled to the cover bottom to support a side surface of the display panel, and stably holds the edge of the display panel, the middle cabinet comprising an area division member configured to separate a first area including a source PCB for driving the display panel and a second area including the sound generating actuator.

The baffle part of the panel vibration type sound generating display device may comprise an adhesive member attached to three sides of the middle cabinet corresponding to the second area, an upper surface of the area division member, and the lower surface of the display panel, and a sealing part disposed outside the adhesive member.

The panel vibration type sound generating display device may further comprise a set PCB, which is disposed at an outer rear surface of the cover bottom and includes a control circuit configured to control the entire display device, wherein a cable passing hole through which a connection cable for electrically connecting the source PCB and the set PCB is to pass is disposed at an area of the cover bottom corresponding to the first area.

The support structure of the panel vibration type sound generating display device comprises a cover bottom supporting the rear side of the display panel, a source PCB for driving the display panel is disposed on a rear surface of one side of the display panel, and a first buffer member spaced from the source PCB by a predetermined distance is placed on an inner surface of the cover bottom corresponding to the source PCB.

A concave part of the panel vibration type sound generating display device may be disposed on the inner surface of the cover bottom corresponding to the source PCB and the first buffer member may be disposed on an upper surface of the concave part.

The cover bottom of the panel vibration type sound generating display device may have a second buffer member disposed thereon, which is in contact with the lower surface of the display panel and the upper surfaces of the cover bottom while separating a first area covering the source PCB and a second area covering the sound generating actuator.

The support structure of the panel vibration type sound generating display device comprises a cover bottom supporting the rear side of the display panel, the display device further comprises a set PCB, which is disposed at an outer rear surface of the cover bottom and includes a control circuit configured to control the entire display device, and a first position in which the sound generating actuator is disposed and a second position in which one or more boards configuring the set PCB are arranged do not overlap each other.

The support structure of the panel vibration type sound generating display device comprises a cover bottom supporting the rear side of the display panel, the sound generating actuator may comprise two or more actuators, which are symmetrically arranged and have different vibration characteristics, the cover bottom may have a reinforcement member disposed thereon, which passes through adjacent positions of the two or more actuators.

The two or more actuators of the panel vibration type sound generating display device may comprise two left sound generating actuators and two right sound generating actuators, and the reinforcement member may be disposed to pass through a middle point of a segment connecting the two left sound generating actuators and a middle point of a segment connecting the two right sound generating actuators.

The panel vibration type sound generating display device may further comprise a sound compensation member, which is lengthily disposed at a position spaced a certain distance apart from an edge of the display panel opposite to a moving direction of the sound generating actuator when the sound generating actuator moves to a destination position spaced a predetermined distance apart from an initial position.

### BRIEF DESCRIPTION OF THE DRAWINGS

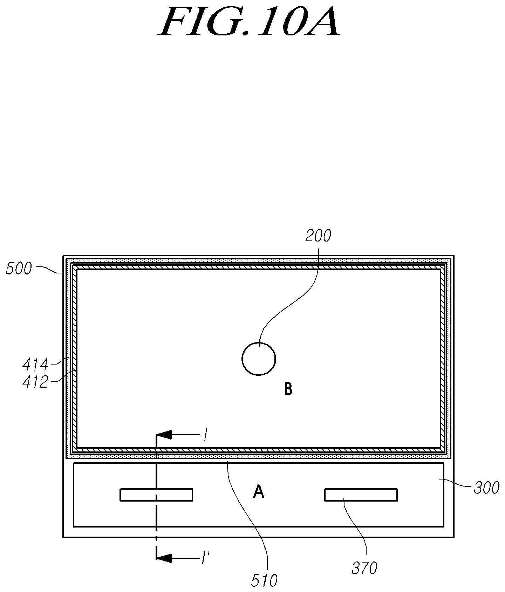

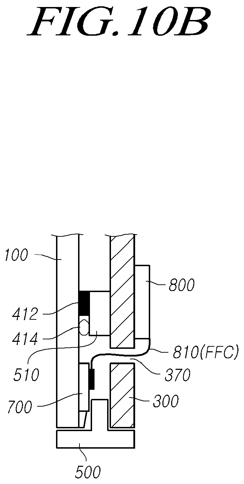

The above and other objects, features and advantages of the present invention will be more apparent from the following detailed description taken in conjunction with the accompanying drawings. It is noted that the following embodiments can only be regarded as embodiments of the claimed subject-matter if the middle cabinet further comprises an area division member as disclosed with regard to Figures 10A and 10B.
FIG. 1 is a schematic plan view of a speaker included in a conventional display device;
FIGs. 2A and 2B are schematic views of a panel vibration type sound generating apparatus according to an embodiment of the present disclosure wherein FIG. 2A is a plan view and FIG. 2B is a sectional view;
FIGs. 3A and 3B are sectional views of two types of sound generating actuators used according to embodiments of the present disclosure;
FIGs. 4A and 4B illustrate a state in which a sound generating actuator according to an embodiment of the present disclosure vibrates a display panel to generate sound;
FIGs. 5A and 5B illustrate an example of a coupling state between a sound generating actuator according to an embodiment of the present disclosure and a cover bottom, which is a supporting structure of a display device;
FIGs. 6A and 6B illustrate other embodiments of a coupling state between a sound generating actuator and a cover bottom;
FIGs. 7A to 7C illustrate an example of a baffle part formed between a display panel and a middle cabinet, which is one of structures for supporting the display panel, in order to form a sound transferring air gap between the display panel, which serves as a vibrating plate, and a cover bottom;
FIG. 8 illustrates a structure of a baffle part which is not an embodiment of the claimed subject-matter in which the adhesive member and the sealing part are placed directly on a cover bottom;
FIGs. 9A and 9B illustrate a locational relation between a source PCB for driving a display panel and a set PCB for driving a set apparatus, which are arranged at the rear surface of a display device;
FIGs. 10A and 10B illustrate an embodiment which further includes an area division member additionally formed on a middle cabinet, and a cable passing hole through which a connection cable (FFC) formed on a cover bottom passes;
FIGs. 11A and 11B are views for describing the relative arrangement between the cover bottom and the source PCB for driving the display panel, and problems of noise generation due to the arrangement;
FIGs. 12A and 12B illustrate an embodiment including a buffer member capable of preventing interference and noise between the source PCB and the cover bottom illustrated in FIGs. 11A and 11B;
FIG. 13 is a graph illustrating a noise reduction effect in the case of using the buffer members of the embodiment illustrated in FIGs. 12A and 12B;
FIG. 14 illustrates a relative arrangement between a sound generating actuator and a set PCB in a display device according to an embodiment of the present disclosure;
FIGs. 15A and 15B illustrate a display device including two or more actuators symmetrically arranged therein, and a distortion of a cover bottom due to a difference of vibration quantity in the display device;
FIGs. 16A and 16B illustrate a structure which has a reinforcement member disposed inside a cover bottom in order to prevent generation of sound distortion by twisting or vibration of the cover bottom;
FIGs. 17A and 17B illustrate specific arrangements of reinforcement members on a cover bottom;
FIGs. 18A and 18B illustrate an embodiment, which further includes a sound compensation member in order to maintain the sound output characteristics when the sound generating actuator has been vertically moved by a reason of design; and
FIG. 19 is a graph illustrating a sound output characteristic in the case of using a panel vibration type sound generating apparatus according to the present embodiment, in comparison with a conventional speaker.

### DETAILED DESCRIPTION OF THE EXEMPLARY EMBODIMENTS

Hereinafter, embodiments of the present disclosure will be described with reference to the accompanying drawings. In assigning reference numerals to elements in the drawings, the same elements will be designated by the same reference numerals as far as possible although they are illustrated in different drawings. Further, in the following description of the present invention, a detailed description of known functions and configurations incorporated herein will be omitted when it may make the subject matter of the present invention rather unclear.

In addition, terms, such as first, second, A, B, (a), (b) or the like may be used herein in describing elements of the present invention. Each of these terminologies is not used to define an essence, order or sequence of a corresponding component but used merely to distinguish the corresponding component from other component(s). In the case that it is described that a certain element "is connected to", "is coupled to", or "is connected with" another element, it should be understood that not only the certain element can be directly connected or coupled to the another element, but also an additional element may be "interposed" between the elements or the elements may be connected or coupled to each other through an additional element.

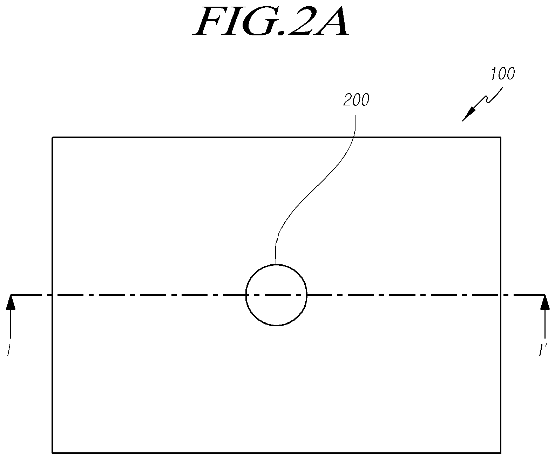

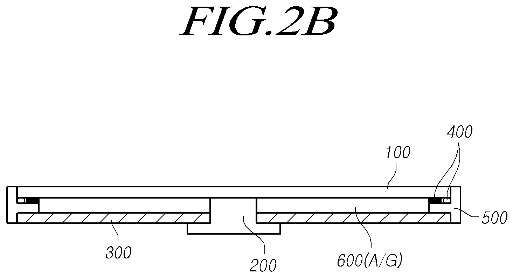

FIGs. 2A and 2B are schematic views of a panel vibration type sound generating apparatus according to the present embodiment, wherein FIG. 2A is a plan view and FIG. 2B is a sectional view.

As shown in FIGs. 2A and 2B, a display device according to the present embodiment includes a display panel 100 configured to display an image, and a sound generating actuator 200 which is attached to a surface of the display panel and vibrates the display panel to generate sound.

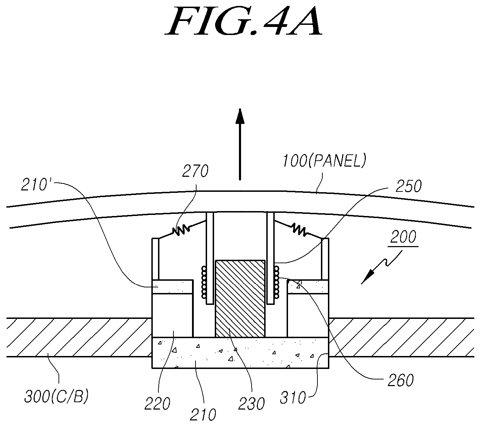

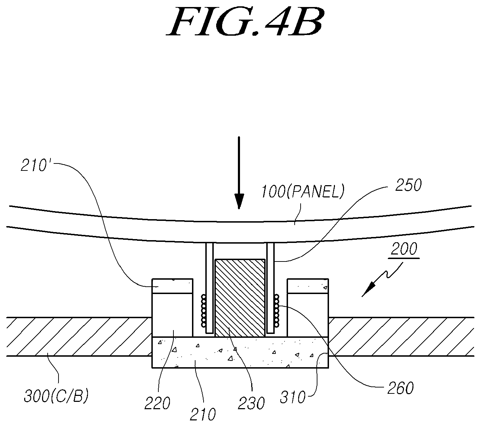

The sound generating actuator 200, which is described below in more detail with reference FIGs. 4A and 4B, includes a magnet, a plate supporting the magnet, a center pole protruding from a central area of the plate, and a bobbin disposed to surround the center pole and having a coil wound thereon, to which an electric current for generating sound is applied, wherein a distal end of the bobbin is attached to one surface of the display panel.

As shown in FIG. 2B, the display device includes a support structure configured to support one or more of the rear surface or a side surface of the display panel, and the plate of the sound generating actuator is fixed to the support structure.

The support structure includes a cover bottom 300 disposed at the rear surface of the display panel, and further includes a middle cabinet 500 which is coupled to the cover bottom while surrounding the side surface of the display panel and receives and supports one side edge of the display panel.

The cover bottom configuring the support structure may be a plate-shaped member made of metal or plastic extending over the entire rear surface of the display device.

It should be construed that the cover bottom 300 in the present disclosure is not limited to the term thereof but may be used as other expressions, such as a plate bottom, a back cover, a base frame, a metal frame, a metal chassis, a chassis base, or m-chassis, and has a concept including all types of frames or plate-shaped structures, which are arranged on the rear base part of the display device as supports for supporting the display panel.

In the present specification, the term "display device" is used not only as a display device in a narrow meaning, such as an OLED module or a Liquid Crystal Module (LCM) including a display panel and a driving unit for driving the display panel, but also as a concept including even a set electronic apparatus or a set apparatus, such as a notebook computer, a television, a computer monitor, and a mobile electronic device such as a smartphone and an electronic pad, which are finished products including such an LCM or OLED module.

That is, in the present specification, a display device is used to have a meaning including not only a display device in a narrow meaning, such as the LCM or OLED module, but also a set apparatus which is an applied product including the same.

For distinguishment, an LCM or OLED module configured by a display panel and a driving unit thereof may be expressed as a "display device" of a narrow meaning, and an electronic apparatus, as a finished product, including such an LCM or OLED module may be expressed as a "set apparatus". For example, the display device in a narrow meaning may include an LCD or OLED display panel and a source PCB, which is a control unit for driving the display panel, and the set apparatus may further include a set PCB, which is a set control unit electrically connected to the source PCB to control the entire set apparatus.

The display panel 100 used in the present embodiment includes all types of display panels including a liquid crystal display panel, an Organic Light Emitting Diode (OLED) display panel, and a Plasma Display Panel (PDP) and is not limited to a specific display panel, as long as the display panel is directly vibrated by the sound generating actuator 200 to generate sound wave.

When the display panel is a liquid crystal display panel, the display panel may include: a plurality of gate lines; a plurality of data lines; pixels defined at intersecting areas between the gate lines and data lines; an array substrate including a thin-film transistor, which is a switching device configured to adjust a light transmission degree at each pixel; an upper substrate including a color filter and/or a black matrix, etc.; and a liquid crystal material layer formed therebetween.

When the display panel is an OLED display panel, the display panel may include: a plurality of gate lines; a plurality of data lines; pixels defined at intersecting areas between the gate lines and data lines; an array substrate including a thin-film transistor, which is a switching device configured to selectively apply a voltage to each pixel; an OLED layer disposed on the array substrate; and a sealing substrate or an encapsulation substrate disposed on the array substrate to cover the OLED layer. The sealing substrate protects the thin film transistor and the OLED layer from an external impact and prevents moisture from permeating the OLED layer.

Although there is no limitation in the type of the display device used in a display device according to the present embodiment, it may be preferred that the display panel is an OLED display panel by the reasons described below.

Specifically, a liquid crystal display panel has many laminated layers and requires an indirect light source type back-light having a separate light source disposed therein. Therefore, when the liquid crystal display panel is directly vibrated by the sound generating actuator 200, the directivity of the liquid crystal material may be shaken and thus cause distortion of an image.

In contrast, since the OLED device of the OLED display panel is an emissive element, the OLED display panel does not require a separate light source and has one panel in which multiple layers including a polarization layer, a glass layer, and an encapsulation layer are integrated. Therefore, even when the OLED display panel is directly vibrated by the sound generating actuator 200, the vibration has nearly no influence on the light emitting property of the organic light emitting layer and thus causes no image distortion. Therefore, in the present embodiment, it is preferred to use an OLED display panel.

The display panel used in a display device according to the present embodiment has a general structure, so a more specific description thereof will be omitted.

The display device according to the present embodiment further includes a baffle part 400 configured to form an air gap, which is a space disposed between the display panel and the cover bottom 300 to transfer the generated sound wave.

That is, by sealingly coupling the display panel to the cover bottom at an edge of the air gap, the air gap is defined as an area sealed in all directions, and such a sealed air gap may be expressed as a baffle structure.

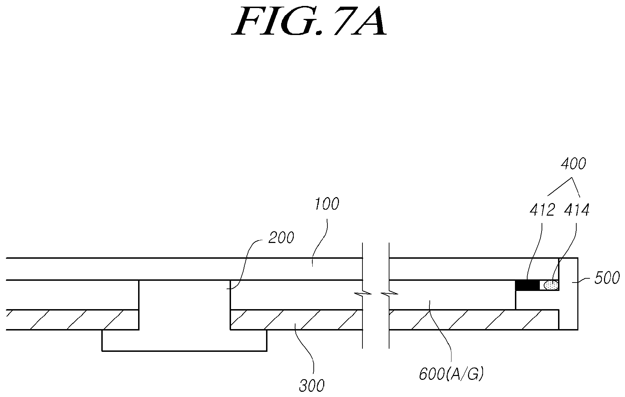

Referring to FIGs. 7A to 7C, the baffle part 400 may include an adhesive part 412, which is disposed at an edge of the cover bottom or middle cabinet and is attached to the lower surface of the display panel, and a sealing part 414 disposed outside the adhesive part to reinforce the sealing of the air gap 600.

The adhesive part 412 may be configured by a double sided tape, it is preferred that the height of the sealing part 414 is higher than the height of the adhesive part 412 as described below in more detail with reference to FIGs. 7A to 7C.

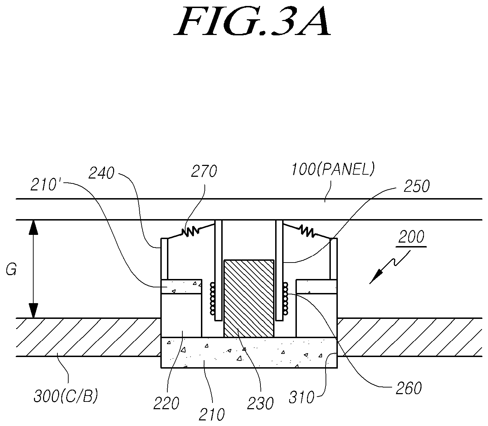

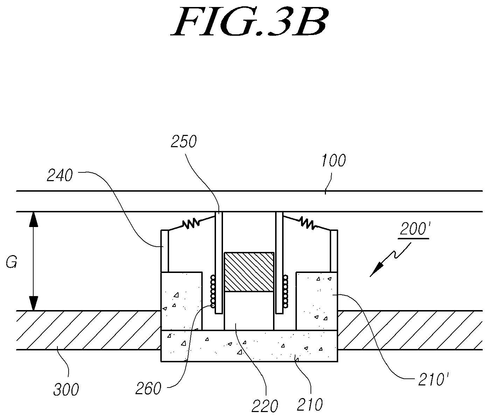

FIGs. 3A and 3B are sectional views of two types of sound generating actuators used according to embodiments of the present disclosure.

A sound generating actuator 200 used in the present embodiment may include a magnet 220, which is a permanent magnet, plates 210 and 210' configured to support the magnet, a center pole 230 protruding from a central area of the plate 210, a bobbin 250 disposed to surround the center pole 230, and a coil 260 wound around the bobbin, wherein an electric current for generating sound is applied to the coil 260.

The sound generating actuator used in the present embodiment may include both a first structure in which the magnet is disposed outside the coil and a second structure in which the magnet is disposed inside the coil.

FIG. 3A illustrates the first structure having the magnet disposed outside the coil, which may be called a dynamic type or an external magnet type.

In the sound generating actuator of the first structure, the lower plate 210 is fixed to a support hole 310 formed at the cover bottom 300 and the magnet 220, which is a permanent magnet having an annular shape, is disposed outside the lower plate.

The upper plate 210' is disposed on the magnet 220, and an external frame 240 protruding from the upper plate is disposed outside the upper plate.

The center pole 230 protrudes from the central area of the lower plate 210 and the bobbin 250 surrounds the center pole 230.

The coil 260 is wound around a lower portion of the bobbin 250, and the electric current for generating sound is applied to the coil.

A damper 270 may be disposed between an upper part of the bobbin and the external frame 240.

The lower plate 210 and the upper plate 210' fix the sound generating actuator 200 to the cover bottom 300 while supporting the magnet 220, the lower plate 210 has a cylindrical shape as shown in FIG. 3A, the magnet 220 having a ring shape is disposed on the lower plate 210, and the upper plate 210' is disposed on the magnet.

As the lower plate 210 and the upper plate 210' are coupled to the cover bottom 300, the magnet 220 disposed between the lower plate 210 and the upper plate 210' can be fixedly supported.

The plate may be formed of a material having a magnetic property, such as ferrite Fe. The plate is not limited to the term thereof and may be expressed by another term, such as a yoke.

The center pole 230 and the lower plate 210 may be integrally formed.

The bobbin 250 is a cylindrical structure formed by paper or aluminum sheet, and the coil 260 is wound around a predetermined lower area of the bobbin. A combination of the bobbin and the coil may be referred to as a voice coil.

When the electric current is applied to the coil, a magnetic field is formed around the coil. Then, due to an external magnetic field formed by the magnet 220, the entire bobbin moves upward while being guided by the center pole according to Fleming's Law.

Meanwhile, since the distal end of the bobbin 250 is attached to the rear surface of the display panel 100, the bobbin vibrates the display panel according to the applying or non-applying of the electric current, and such a vibration generates a sound wave.

The magnet 220 may use a sintered magnet, such a barium ferrite, and may use a cast magnet made from an alloy of ferric oxide (Fe2O3), barium carbonate (BaCO3), strontium ferrite having an improved magnetic component, aluminum (Al), nickel (Ni), and cobalt (Co), without being limited thereto.

A damper 270 is disposed between an upper part of the bobbin 250 and the external frame 240, and the damper 270 has a wrinkle structure and thus contracts or expands to adjust the up-down vibration of the bobbin according to the up-down movement of the bobbin. That is, since the damper 270 is connected to the bobbin 250 and to the external frame 240, the up-down vibration of the bobbin is restricted by the restoring force of the damper 270. Specifically, when the bobbin 250 vibrates upward beyond a predetermined height or downward beyond a predetermined level, the restoring force of the damper 270 can return the bobbin to its original position.

The damper may be expressed by another term, such as an edge.

FIG. 3B illustrates the second structure having the magnet disposed inside the coil, which may be expressed as a micro type or an internal magnet type.

In the sound generating actuator of the second structure, the lower plate 210 is fixed to a support hole 310 formed at the cover bottom 300, the magnet 220 is disposed at a central area of the lower plate, and the center pole extends upward from the top of the magnet.

The upper plate 210' protrudes from a peripheral part of the lower plate, and the external frame 240 is disposed on the edge of the upper plate.

The bobbin 250 is disposed to surround the magnet 220 and the center pole 230, and the coil 260 is wound around the bobbin.

The damper 270 is disposed between the external frame 240 and the bobbin.

The sound generating actuator of the second structure has a smaller leakage of magnetic flux than that of the first structure and can have a reduced entire size. However, the sound generating actuator of the second structure may undergo reduction of magnetic flux due to a large current input and is difficult to manufacture.

In the present embodiment, both the actuators of the first structure and the second structure may be used, and the following description discusses the first structure as a representative for convenience of description.

The sound generating actuator used in a display device according to the present embodiment is not limited to the type illustrated in FIGs. 3A and 3B, and includes other types of actuators as long as the actuators can vibrate a display panel up and down to generate sound in response to application of the electric current.

FIGs. 4A and 4B illustrate a state in which a sound generating actuator according to an embodiment of the present disclosure vibrates a display panel to generate sound.

FIG. 4A illustrates a state in which the electric current has been applied, wherein the center pole connected to the lower surface of the magnet serves as the N pole and the upper plate connected to the upper surfaces of the magnet serves as the S pole to establish an external magnetic field between coils.

In this state, if an electric current for generating sound is applied to a coil, an applied magnetic field is generated around the coil. The applied magnetic field generates, together with the external magnetic field, a force of moving the bobbin upward.

By the force, the bobbin moves upward and the display panel coupled to the distal end of the bobbin moves upward, as shown in FIG. 4A.

In this state, if the application of the electric current is interrupted or the electric current is applied in the opposite direction, a force of moving the bobbin downward is generated in the same principle, and the display panel thus moves downward.

In this way, according to the direction and magnitude of the electric current applied to the coil, the display panel vibrates up and down to generate sound wave.

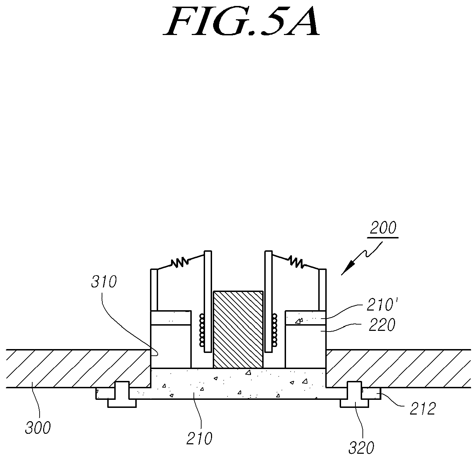

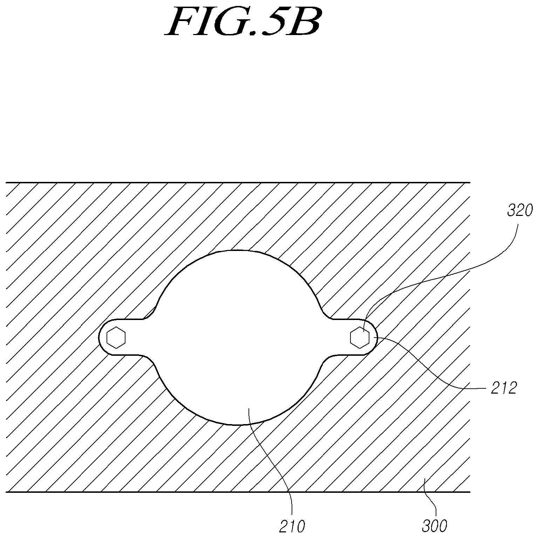

FIGs. 5A and 5B illustrate an example of a coupling state between a sound generating actuator according to an embodiment of the present disclosure and a cover bottom, which is a supporting structure of a display device.

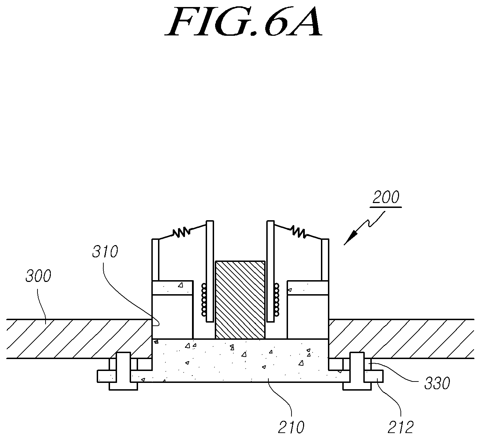

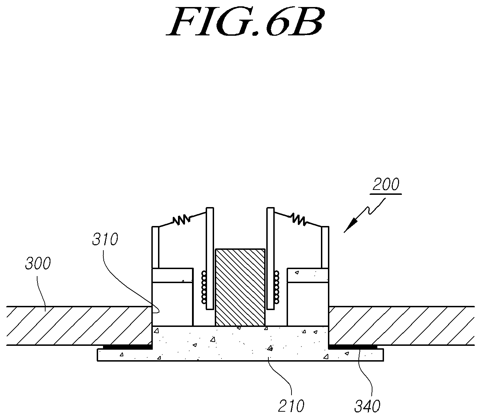

FIGs. 6A and 6B illustrate other embodiments of a coupling state between a sound generating actuator and a cover bottom.

The sound generating actuator 200 according to the present embodiment may be inserted through and supported by a support hole formed on a cover bottom or back cover, which is a support structure of a display device. FIGs. 5A to 6B illustrate various support structures.

In the support structure of FIG. 5, a support hole 310 is formed through the cover bottom 300, and at least one among the lower plate 210 of the sound generating actuator 200, the magnet 220, and the upper plate 210' is inserted and received in the support hole.

An extension part 212 extending outward from the lower plate is additionally formed on the lower surface of the lower plate 210, and the extension part 212 is fixed to the lower surface of the cover bottom 310 to allow the sound generating actuator 200 to be mounted to the cover bottom.

In this way, when the sound generating actuator 200 is inserted in and fixed to the support hole formed through the cover bottom, the distance between the display panel and the cover bottom can be reduced to thereby reduce the thickness of the display device.

In other words, although an air gap as a space in which the display panel can vibrate should be arranged between the display panel and the cover bottom, the sound generating actuator inserted in/fixed to the support hole of the cover bottom can minimize the air gap due to the reduced height of the sound generating actuator disposed between the rear surface of the display panel and the innner surface of the cover bottom.

In the structure illustrated in FIGs. 5A and 5B, a screw hole is formed on the rear surface of the cover bottom, and a bolt 320 or a screw is fastened through the screw hole formed through the extension part 212 of the lower plate to the screw hole of the cover bottom to fix the sound generating actuator to the cover bottom.

Meanwhile, in the structure illustrated in FIG. 6A, which is not a simple screw-coupling structure, a PEM^{™} nut 330 or self-clinching nut is placed to secure a predetermined distance between the cover bottom 300 and the extension part 212 of the lower plate, and the actuator is then fixed by the bolt 320.

Use of the PEM nut 330 or self-clinching nut as shown in FIG. 6B can secure a predetermined space between the sound generating actuator and the cover bottom and thus can minimize the transferring of the vibration of the actuator to the cover bottom.

In the structure shown in FIG. 6B, an adhesive member, such as a double-sided tape, is disposed between the cover bottom and the extension part 212 of the lower plate of the actuator to attach and fix them to each other.

When the adhesive member as shown in FIG. 6B has a properly adjusted elasticity and thickness, the adhesive member can function as a kind of damper to minimize the transferring of the vibration of the actuator to the cover bottom.

The structure as shown in FIGs. 5A to 6B in which the sound generating actuator 200 attached to the display panel to directly vibrate the display panel is inserted in and fixed to a support hole formed through the cover bottom can reduced the thickness of the display device in comparison with the structure in which the actuator is completely received in the display device.

FIGs. 7A to 7C illustrate an example of a baffle part formed between a display panel and a middle cabinet, which is one of structures for supporting the display panel, in order to form an air gap between the display panel, which serves as a vibrating plate, and a cover bottom.

As shown in FIG. 7A, the panel vibration type sound generating apparatus according to the present embodiment should secure an air gap 600, which is a space allowing the panel to be vibrated by the sound generating apparatus 200, between the display panel 100 and a support structure (cover bottom 300).

Further, one side of the display panel should be coupled to the support structure of the display panel to generate sound wave during the vibration of the display panel. Especially, the generated sound should not leak to the outside through a side, etc. of the display device.

To this end, the display device according to the present embodiment has a baffle part 400 formed between the lower surface of the display panel and the support structure.

Specifically, a predetermined section (that is, air gap) is defined around the sound generating actuator, a baffle part is disposed between the upper surface of the middle cabinet and the lower surface of the display panel at an edge of the section, and the baffle part 400 may include an adhesive member 412, such as a double-sided tape attached between the lower surface of the display panel and the upper surface of the support structure of the display device, and a sealing part 414 disposed outside the adhesive member.

The section in which the baffle part is formed may be the entire display panel area defined by four outer sides of the display panel. However, the section is not limited to such a definition and may be defined by an area excluding the area in which a source PCB is disposed, as described below.

When two or more sound generating actuators are arranged to implement stereo or three-dimensional sound, two or more sections may be separately arranged to form the baffle part.

As shown in FIGs. 7A to 7C, the support structure of the display device includes a middle cabinet 500, which is coupled to the cover bottom and is configured to allow a part of the display panel to be stably placed thereon, in addition to the cover bottom 300 covering the entire rear surface of the display panel.

The middle cabinet 500 is a frame-shaped member formed along the outer periphery of the display panel, and includes a horizontal support part 502 on which a part of the display panel is stably placed, and a vertical support part 504 bent perpendicularly in opposite directions from the horizontal support part to cover the side surface of the cover bottom and the side surface of the display panel. Therefore, the middle cabinet may have a shape of a letter "T" in general.

The middle cabinet 500 configures an external ornamental part of the side surface of the display device or set apparatus, and may not be used or integrally formed with the cover bottom in some cases.

According to the embodiment of FIG. 7A, the adhesive member 412 configuring the baffle part 400 is a double-sided tape disposed between the upper surface of the horizontal support part of the middle cabinet 500 and the display panel and fixes the lower surfaces of the display panel to the middle cabinet.

The sealing part 414 configuring the baffle part is placed outside of the adhesive member and preferably has a thickness or height larger than the thickness or height of the adhesive member.

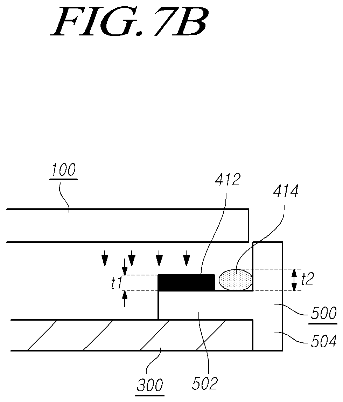

The sealing part 414 may be made from a material, such as rubber having a large elasticity, and has a thickness t2 larger than the thickness t1 of the adhesive member 412 as illustrated in FIG. 7B.

That is, as illustrated in FIG. 7B, one adhesive surface of the adhesive member 412, which is a double-sided tape having a thickness t1, is attached to the inner part of the upper surface of the horizontal support part 502 of the middle cabinet 500, and the sealing part 414 made of an elastic material having a thickness larger than t1 is disposed outside the adhesive member.

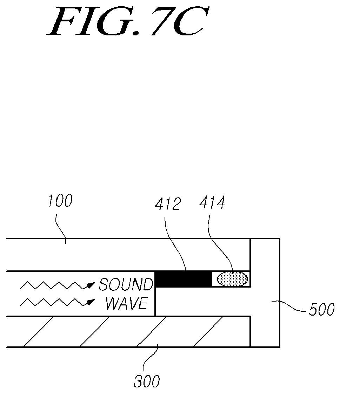

In this state, the display panel 100 is attached to the other adhesive surface of the adhesive member 412. Then, the display panel is attached to the middle cabinet while pressing, to a certain degree, the sealing part 414 having the larger thickness. (FIG. 7C)

As a result, the sealing of the air gap around the sound generating actuator is further enhanced.

The structure illustrated in FIG. 7C in which the display panel 100 and the cover bottom 300 are coupled to each other while forming the air gap 600 to be as wide as the thickness of the adhesive member 412 and the horizontal support part 502 of the middle cabinet can secure a vibration space in which the display panel can generate sound, and can prevent the internally generated sound wave from leaking to the outside along the side surface of the display device.

The baffle part 400 disposed at an edge of the air gap, which has a double structure of the adhesive member 412 and the sealing part 414 while allowing the sealing part to have a larger thickness, can further enhance the sealing of the air gap and prevent leakage of the sound.

It should be construed that the middle cabinet 500 used in the present specification may be replaced by another term, such as a guide panel, a plastic chassis, a p-chassis, a support main, a main support, or a mold frame, and includes all types of members, which are structures having a shape of a four-sided frame and having a sectional shape including multiple bent portions and are connected to the cover bottom to be used to support the display panel and the baffle part.

The middle cabinet 500 may be made of synthetic resin, such as polycarbonate, by injection molding, without being limited thereto.

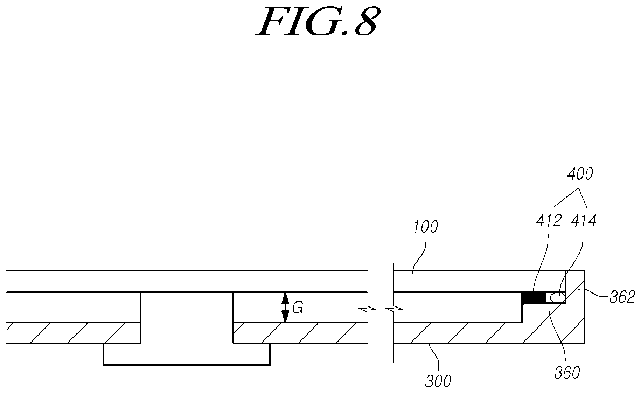

FIG. 8 illustrates a structure of a baffle part according to another embodiment in which the adhesive member and the sealing part are placed directly on a cover bottom.

Although a middle cabinet is used to support the cover bottom and the display panel in the embodiment described above, the middle cabinet may not be always required.

The embodiment illustrated in FIG. 8 is not according to the claimed subject-matter and shows a structure in which the cover bottom 300 supports one side of the display panel while forming an external appearance of the side surface of the display device without a middle cabinet.

The structure illustrated in FIG. 8 includes a cover bottom 300 in which a step portion 360 protrudes upward from a base surface at one side of the cover bottom 300 and a side surface supporting part 362 vertically extends from the outside of the step portion 360.

A part of the edge of the display panel 100 is stably placed on and attached to the step portion 360 of the cover bottom 300, the side surface support part 362 of the cover bottom surrounds and protects the side surface of the display panel 100, and the cover bottom resultantly forms an external ornamental part of the entire side and rear surfaces of the display device.

In this structure, in order to configure the baffle part 400 for generation of sound, the adhesive member 412 in the form of a double-sided tape is disposed inside the step portion 360 of the cover bottom and the sealing part 414 having a thickness larger than that of the adhesive member is disposed outside the adhesive member.

In this state, the display panel 100 is placed on the step portion 360 of the cover bottom and is attached to one adhesive surface of the adhesive member 412, so that the display panel is coupled to the cover bottom. Then, the sealing part 414 is compressed to secure and enhance the sealing of the air gap for transfer of sound.

The embodiment of FIG. 8 has a simple structure without a middle support structure like the middle cabinet and includes the baffle part 400, which is disposed at an edge of the air gap and has a double structure of the adhesive member 412 and the sealing part 414 while allowing the sealing part to have a larger thickness. Therefore, the embodiment of FIG. 8 can secure a vibration space in which the display panel can generate sound, and can prevent the internally generated sound wave from leaking to the outside along the side surface of the display device.

The thickness of the air gap, that is, the distance G between the display panel and the cover bottom, may have a value of about 1.0 to 3.0 mm in the present embodiment. However, the thickness is not limited to the range and may have a value in a range different according to the degree of vibration of the display panel, etc.

However, in order to reduce the thickness of the display device, it is preferable to minimize the thickness G of the air gap in consideration of the quantity of vibration of the display panel by the sound generating actuator, the range of sound to be output, and the quantity of output. In the present embodiment, it has been confirmed that an optimum thickness of the air gap G is about 2.0 mm.

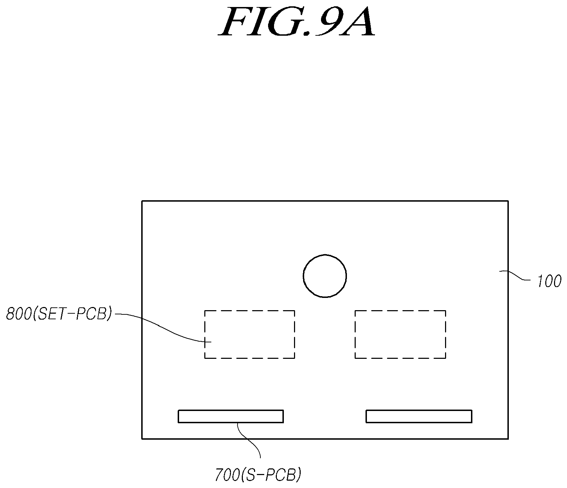

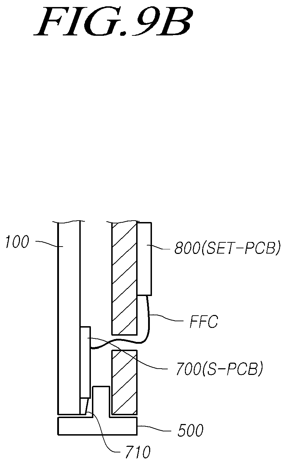

FIGs. 9A and 9B illustrate a locational relation between a source PCB for driving a display panel and a set PCB for driving a set apparatus, which are arranged at the rear surface of a display device.

As shown in FIGs. 9A and 9B, the display device includes a source PCB, which is a circuit board including a Source Driver Integrated Circuit (S-DIC) for driving a display panel to drive data lines formed on the display panel and is referred to as simply "S-PCB".

The display device or a set apparatus including the same is connected to the S-PCB and may further include a Control Printed Circuit Board (C-PCB) having control parts and various electric devices mounted thereon to generally control the display device or set apparatus.

Specifically, an OLED display device, to which the present embodiment is applicable, may include: an OLED display panel 100 including a plurality of data lines DL, a plurality of gate lines, and a plurality of sub-pixel SP arranged thereon; a data driver configured to drive the plurality of data lines DL; a gate driver configured to drive the plurality of gate lines GL; and a controller configured to control the data driver and the gate driver.

The controller supplies various control signals to the data driver and the gate driver to control the data driver and the gate driver, starts scanning according to a timing implemented in each frame, converts image data input from the outside into a data signal format used in the data driver and outputs a converted image data, and properly controls the driving of the data driver according the scanning.

The controller may be a timing controller used in a general display technology or may be a control apparatus including a timing controller to further perform another control function.

The data driver supplies a data voltage to the plurality of data lines DL to drive the data lines DL. Herein, the data driver is also referred to as a "source driver".

The data driver may include at least one Source Driver Integrated Circuit (S-DIC) to drive the plurality of data lines.

The gate driver sequentially supplies a scan signal to the plurality of gate lines GL to sequentially drive the gate lines GL. The gate driver is also referred to as a "scan driver" and may include at least one Gate Driver Integrated Circuit (G-DIC).

Each Source Driver Integrated Circuit (S-DIC) may be connected to a bonding pad of an OLED display panel either by a Tape Automated Bonding (TAB) method or a Chip On Glass (COG) method or directly. In some cases, S-DICs may be integrated and arranged in an OLED panel. Further, each S-DIC may be packaged on a film connected to an OLED display panel by a Chip On Film (COF) method.

That is, a display device, to which the present embodiment is applicable, may include: at least one Source Printed Circuit Board (S-PCB) necessary for circuit connection of at least one Source Driver Integrated Circuit (S-DIC); and a Control Printed Circuit Board (C-PCB) or set PCB configured to mount control parts for controlling the entire display device and various electric devices thereon.

Here, at least one S-DIC may be mounted on or a Chip-On Film (COF) having at least one S-DIC mounted thereof may be connected to the at least one source PCB.

The C-PCB or set PCB 800 may include a controller configured to control operations of the data driver and the gate driver, and a Power Management IC (PMIC) configured to supply various voltages or currents to the display panel, the data driver, and the gate driver or control the various voltages or currents to be supplied.

The source PCB is usually located at one side among the upper side and the lower side of a display panel. However, according to the driving scheme or panel design scheme, the source PCB may be arranged on both the upper side and the lower side.

That is, as shown in FIGs. 9A and 9B, the source PCB 700 is connected to the display panel 100 and the COF 710 and is disposed on a lower rear surface of the display panel.

The C-PCB or set PCB 800 may be disposed at the outer rear side of the cover bottom 300 and connected through a flexible cable to the source PCB 700 located inside the cover bottom.

In the structure shown in FIGs. 9A and 9B, it is difficult to configure a baffle part as described above with reference to FIGs. 7A to 7C, at the lower side of the display panel having the sound generating actuator 200 mounted thereon.

In other words, since the source PCB 700 and the chip-on film 710 connected thereto are arranged in the vicinity of the lower side of the display panel, it is difficult to arrange the baffle part 400 including the adhesive member 412 and the sealing part 414, and the sealing of the air gap may be degraded even when the baffle part is arranged.

Further, the generated sound may leak backward through a cable passing hole, which is formed through a part at the lower side of the cover bottom to enable a flexible cable for connection between the source PCB 700 disposed inside the cover bottom and the set PCB 800 disposed outside the cover bottom to pass therethrough.

Therefore, in order to apply a sound generating apparatus of the present embodiment to a display device having the structure as shown in FIGs. 9A and 9B, it is necessary to solve the problems of degradation in the sealing of the baffle part and the sound leakage. In this respect, the embodiment shown in FIGs. 10A and 10B is presented.

FIGs. 10A and 10B illustrate an embodiment which further includes an area division member additionally formed on a middle cabinet, and a cable passing hole through which a connection cable (FFC) formed on a cover bottom passes.

The embodiment illustrated in FIGs. 10A and 10B has a structure, which further includes an area division member 510 configured to partition the middle cabinet into two or more areas and has a baffle part formed on the area division member, in order to solve the problems of the structure described above with reference to FIGs. 9A and 9B.

The area division member 510 divides the entire area of the middle cabinet surrounding the entire display panel into a first area A in which the source PCB is included and a second area B in which the source PCB is not included, wherein the sound generating actuator 200 is disposed in a part of the second area B.

The area division member may be manufactured in the form of a bar having a thickness corresponding to the horizontal support part of the middle cabinet to be attached to the middle cabinet 500 through welding, etc. However, the present disclosure is not limited thereto and the entire middle cabinet including the area division member 510 may be integrally manufactured as one unit.

As shown in FIG. 10A, an area division member 510 is lengthily disposed in the horizontal direction of the display device, and an adhesive member 412 and a sealing part 414 are arranged on the upper side of the area division member 510 and three sides of the middle cabinet corresponding to the second area B.

FIG. 10B is a sectional view taken along line I-I' of FIG. 10A, in which the adhesive member 412 and the sealing part 414 are arranged on the upper side of the area division member 510 to seal the second area B as an air gap.

In a part of the lower area of the cover bottom 300, specifically, among the areas divided by the area division member 510, a cable passing hole 370, through which a connection cable 810 connecting the source PCB 700 and the set PCB 800 is to pass, is formed in the first area A including the source PCB.

The structure as shown in FIGs. 10A and 10B in which only the second area B including no source PCB is formed as a sound generating area can minimize the degradation of the sealing of the sound generating area by interference of the source PCB.

Further, the cable passing hole 370 disposed in the first area A including the source PCB can prevent the sound leakage through the cable passing hole.

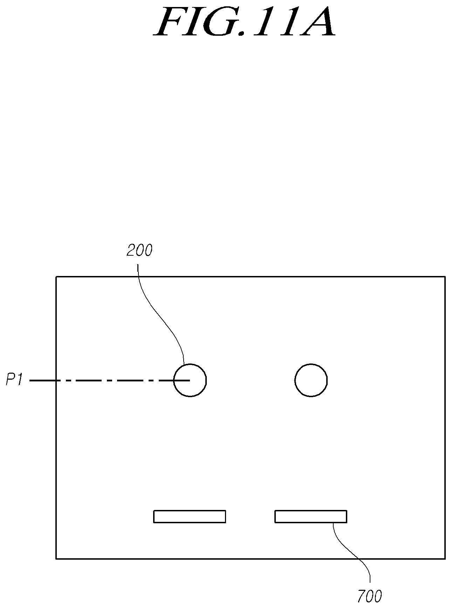

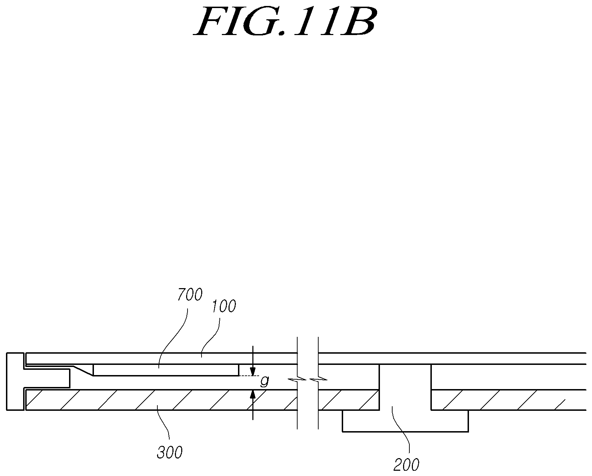

FIGs. 11A and 11B are views for describing the relative arrangement between the cover bottom and the source PCB for driving the display panel, and problems of noise generation due to the arrangement.

As shown in FIG. 11A, a source PCB 700 including an S-DIC or data driver is connected to the display panel through a chip-on film, etc., and is disposed at one side (lower side) of the display panel.

A gap g is formed between the source PCB and the cover bottom in the area in which the source PCB is disposed, and is smaller than a gap between the source PCB and the cover bottom in the other area.

Therefore, when the sound generating actuator 200 according to the present embodiment is arranged and vibrates the display panel, the source PCB integrally vibrating the display panel may collide with the cover bottom in the area in which the source PCB is placed.

The collision between the source PCB and the cover bottom may generate noise and may even damage the source PCB.

Further, even without direct collision between the source PCB and the cover bottom, the strong vibration of the display panel at the time of sound generation may have an influence on the performance of the source PCB when the vibration is continuously transferred to the source PCB.

In order to solve this problem, a solution of arranging a buffer member for protecting the source PCB between the source PCB and the cover bottom or between the display panel and the cover bottom is proposed.

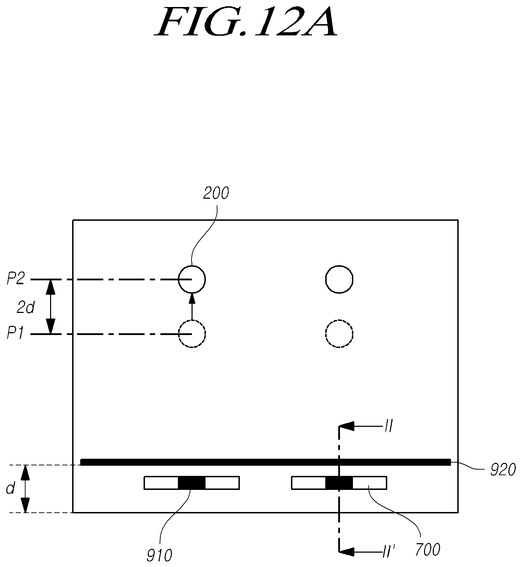

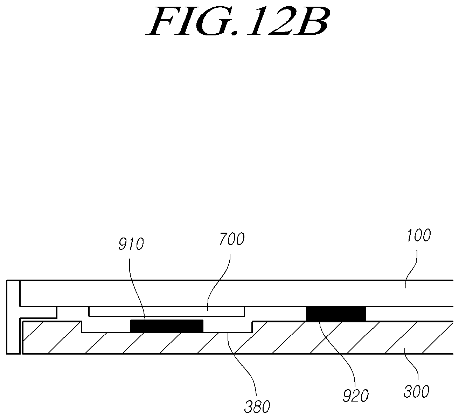

FIGs. 12A and 12B illustrate an embodiment including a buffer member capable of preventing interference and noise between the source PCB and the cover bottom illustrated in FIGs. 11A and 11B.

In the embodiment of FIGs. 12A and 12B, a source PCB 700 including a circuit element for driving the display panel is disposed at the rear surface of the display panel, a recessed part 380 is formed in an area of the cover bottom, which faces the source PCB, and a first buffer member 910 having a predetermined elasticity is placed on the upper surface of the concave part 380. The recessed part 380 may be concave, for example.

Further, a second buffer member 920 lengthily extending along one direction may be additionally disposed on the cover bottom.

Specifically, as shown in FIG. 12A, the display panel may be divided into a first area A covering the source PCB and a second area B covering the sound generating actuator, and the second buffer member 920 is preferably disposed to lengthily extend to separate the first area A and the second area B from each other.

Of course, although not illustrated, the baffle part 400 including the adhesive member 412 and the sealing part 414 described above with reference to FIGs. 7A to 8 may be disposed on all of the four sides of the display panel in the embodiment of FIGs. 12A and 12B.

The first buffer member 910 and the second buffer member 920 may be configured by a one-sided tape or double-sided tape. However, the present disclosure is not limited thereto, and the buffer member may include all types of members formed of rubber, plastic, paper, or other materials, which have a predetermined elasticity.

It is preferred that the first buffer member 910 is disposed on the concave part 380 of the cover bottom while the upper surface of the first buffer member 910 is spaced a predetermined distance apart from the source PCB and the second buffer member 920 has one surface in contact with the cover bottom and the other surface in contact with the lower surface of the display panel.

Of course, without the concave part 380 of the cover bottom, the first buffer member 910 may be placed on a part of the upper surface of the cover bottom, which faces the source PCB.

As shown in FIG. 12B, the concave part 380 formed at the cover bottom area corresponding to the source PCB increases the gap between the source PCB and the cover bottom to reduce the possibility that the source PCB may collide with the cover bottom even when the display panel vibrates to generate sound.

Moreover, the first buffer member 910 disposed on the concave part 380 of the cover bottom can buffer a large vibration of the display panel even when the source PCB moves toward the concave part of the cover bottom due to the large vibration, so as to reduce the generation of noise due to interference between the source PCB and the cover bottom and reduce the possibility of damage of the source PCB.

Further, when the display panel vibrates in the second area B, which is the sound generation area, the second buffer member 920 can prevent the vibration from being transferred to the source PCB 700 disposed on the rear surface of the display panel to some degree, and thus can minimize the degradation of performance of the source PCB due to continuous vibration of the display panel.

The location of the sound generating actuator may be changed according to the arrangement of the second buffer member 920.

That is, as shown in FIG. 12A, when the second buffer member 920 is spaced a distance d apart from the lower side of the display panel, the sound generating actuator 200 may be moved by about 2d from the initial position P1 and is then installed at position P2.

It has been confirmed that changes in the sound output characteristics according to the installation of the second buffer member could be minimized by moving the sound generating actuator by about twice that of the space d between the second buffer member 920 and one side of the display panel.

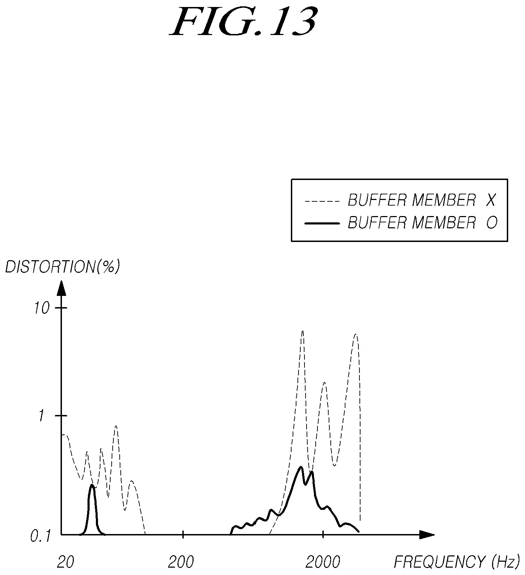

FIG. 13 is a graph illustrating a noise reduction effect in the case of using the buffer members of the embodiment illustrated in FIGs. 12A and 12B.

As a result of actual experiments, it has been confirmed that, when the first buffer member 910 and the second buffer member 920 described above with reference to FIGs. 12A and 12B are not used, much unnecessary noise was generated in a low sound range of several dozens of Hz and in a sound range of 1000 Hz or higher, as noted from the dotted line of FIG. 13.

In contrast, as noted from the solid line of FIG. 13, the noise is largely reduced in the corresponding bands when the buffer members of FIGs. 12A and 12B are used.

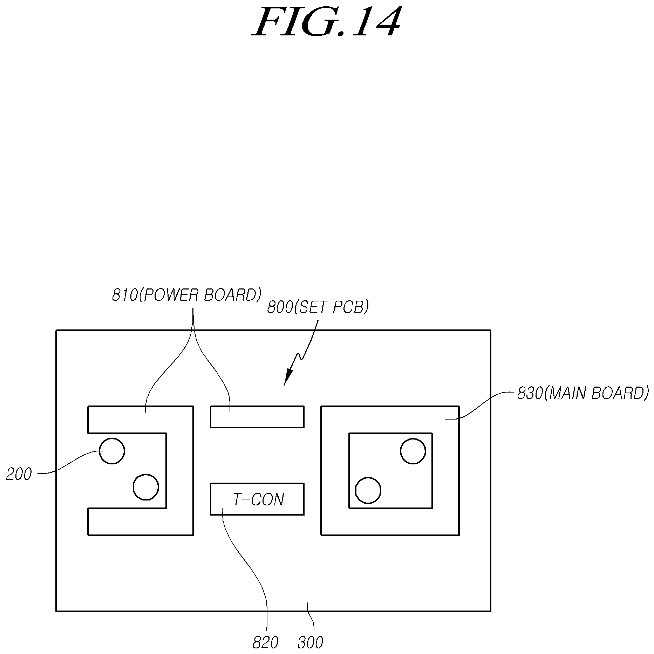

FIG. 14 illustrates a relative arrangement between a sound generating actuator and a set PCB in a display device according to an embodiment of the present disclosure.

In general, a display device or a set apparatus including the display device includes not only a source PCB including a control circuit (data driver IC, etc.) for driving a touch function or a data line of a display panel, but also a set PCB connected to the source PCB to control the display device or the entire set apparatus and supply power thereto.

As described above with reference to FIGs. 10A and 10B, the source PCB is attached to the rear surface of the display panel and the set PCB is attached to the outer side of the rear surface support structure of the display device, such as a cover bottom or a back cover.

The embodiment of FIG. 14 provides a display device in which a sound generating actuator is placed at a first position of a support structure of the display device and a set PCB of a set apparatus is placed at a second position different from the first positions, so as to avoid interference between the sound generating actuator and the set PCB.

As illustrated in FIG. 14, the set PCB 800 placed on the rear surface of the cover bottom may include a power board 810 configured to supply power to the display panel, a timing controller 820 configured to generate a timing pulse or a timing signal for driving a gate line or data line, and a main board 830 including a control circuit for controlling the entire display device or set apparatus.

Boards 810, 820, and 830 of the set PCB 800 are attached to the rear surface of the cover bottom 300, and the sound generating actuator 200 is fixedly inserted in a support hole formed through the cover bottom as described above.

Therefore, it is preferable to place the sound generating actuator 200 (first position) and the set PCB (second position) at different positions, as shown in FIG. 14, to avoid interference therebetween.

Even when the sound generating actuator 200 is fixed within the cover bottom, if the positions of the sound generating actuator and the set PCB overlap, the vibration of the sound generating actuator may be continuously transferred to the circuit elements of the set PCB to have a bad influence on the performance of the set PCB.

Therefore, the arrangement of the sound generating actuator 200 (first position) and the set PCB (second position) at different positions as shown in FIG. 14 facilitates the arrangement design of elements and can minimize the degradation of the performance of the set PCB.

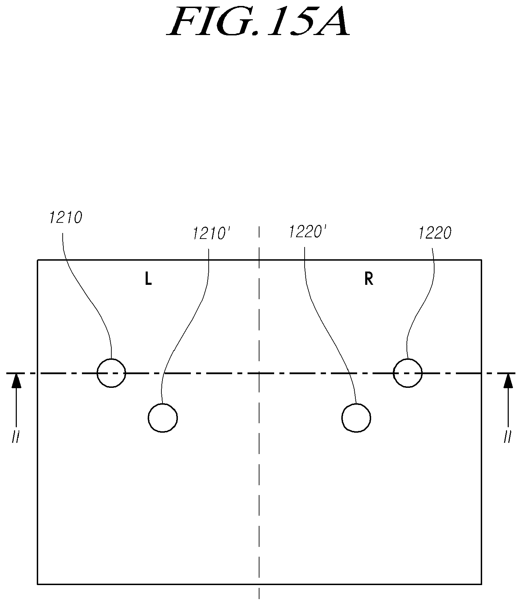

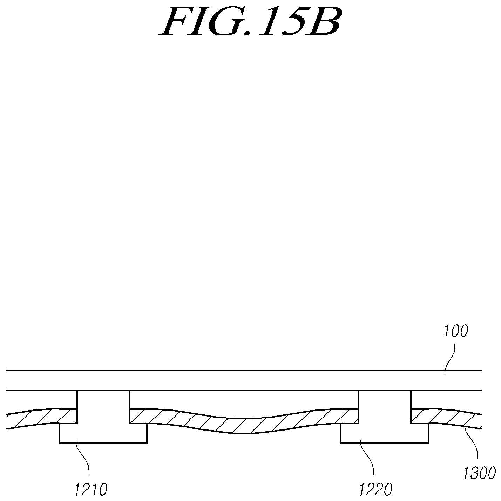

FIGs. 15A and 15B illustrate a display device including two or more actuators symmetrically arranged therein, and a distortion of a cover bottom due to a difference of vibration quantity in the display device.

According to the present embodiment, a plurality of sound generating actuators may be symmetrically arranged at left and right portions or upper and lower portions of the display panel to output different sounds at the areas.

For example, as shown in FIG. 15A, in order to implement stereo sound, one or two left sound generating actuators 1210 and 1210' are arranged at the left side of the display panel, one or two right sound generating actuators 1220 and 1220' are arranged at the right side of the display panel, and the left and right actuators may be differently vibrated.

As shown in FIG. 15B, which is a sectional view taken along line II-II' of FIG. 15A, when the different vibrations of the left and right actuators 1210 and 1220 are continuously repeated, the vibration difference between the left side and right side of the cover bottom 1300 is continuously accumulated.

Since the cover bottom is usually manufactured to have as thin a thickness as possible, the accumulation of the vibration difference between the left side and right side of the cover bottom may cause the cover bottom to be curved or deformed. That is, as shown in FIG. 15B, the cover bottom 1300 may be twisted or deformed. Further, even when the cover bottom 1300 is not deformed, the vibration difference of the cover bottom due to the vibration difference between the left and right actuators may cause distortion of the generated sound.

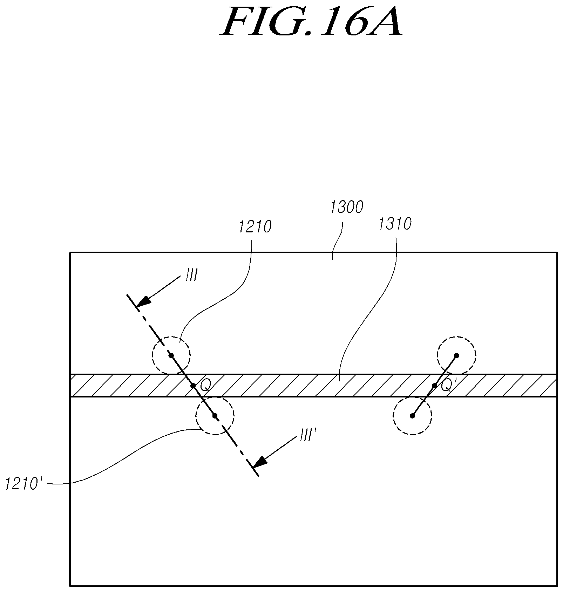

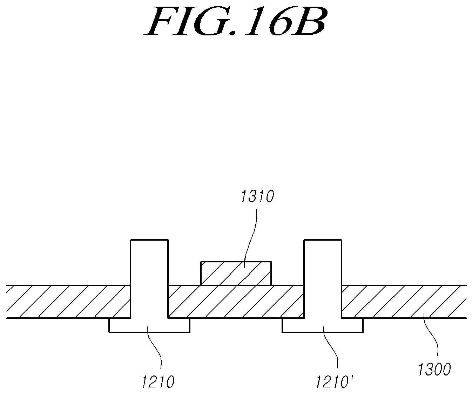

In order to solve this problem, a structure as shown in FIGs. 16A and 16B, which has a reinforcement member disposed inside a support structure of a display device while using two or more sound generating actuators is proposed.

FIGs. 16A and 16B illustrate a structure which has a reinforcement member disposed inside a cover bottom in order to prevent generation of sound distortion by twisting or vibration of the cover bottom.

In the embodiment illustrated in FIGs. 16A and 16B, at least one reinforcement member 1310 may be disposed inside or outside of the cover bottom in order to prevent deformation of the cover bottom or sound distortion by the unbalanced vibration of the cover bottom in the case of using multiple sound generating actuators having different vibration characteristics as described with reference to FIGs. 15A and 15B.

The reinforcement member 1310 may be formed to have a shape of a long bar passing through a portion adjacent to multiple sound generating actuators and are preferably arranged at particular positions to optimize the reinforcement characteristics.

As shown in FIG. 16A, when two left sound generating actuators 1210 and 1210' and two right sound generating actuators 1220 and 1220' are arranged, the reinforcement member 1310 may be disposed to extend through a middle point Q between the two left sound generating actuators 1210 and 1210' and a middle point Q' between the two right sound generating actuators 1220 and 1220'.

This arrangement can optimize the reinforcement performance of the reinforcement member 1310 even when the two left and right sound generating actuators have different vibration characteristics.

The reinforcement member 1310 may be manufactured in the form of a separate metal bar and is then attached to the inner surface of the cover bottom as shown in FIG. 16B, to which the present disclosure is not limited.

For example, the cover bottom may be manufactured through injection molding, and may have a reinforcement member 1310 integrally formed by protruding a part of the inner surface of the cover bottom.

The reinforcement member 1310 is not inevitably disposed on the inner surface of the cover bottom, but may be disposed on the outer surface of the cover bottom. However, in consideration of an external appearance and the thickness of the display device, it is preferred that the reinforcement member is disposed on the inner surface of the cover bottom 1300.

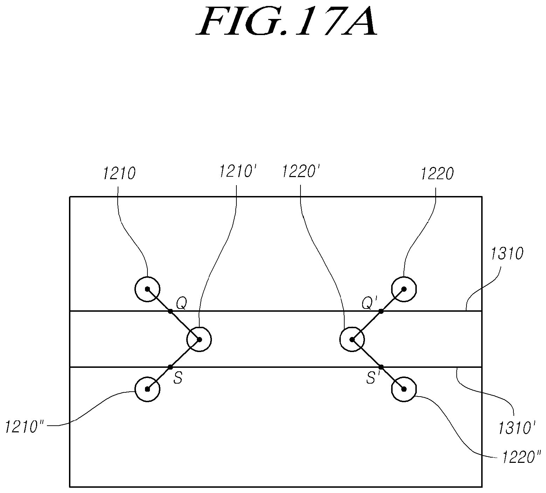

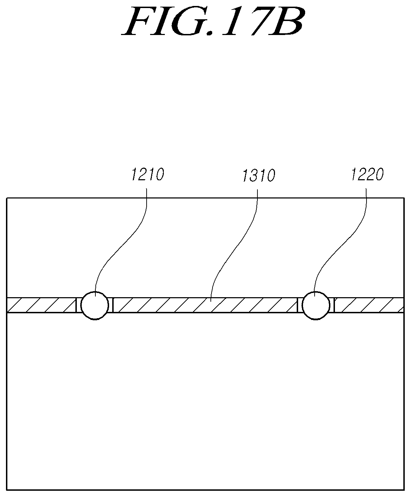

FIGs. 17A and 17B illustrate specific arrangements of reinforcement members on a cover bottom.

FIG. 17A illustrates a structure in which three sound generating actuators are arranged at each of the left side and right side thereof and two reinforcement members 1310 and 1310' are arranged, wherein a first reinforcement member 1310 is disposed to extend through middle points Q-Q' of segments, each of which connects to two upper actuators among the three left or right sound generating actuators, and a second reinforcement member 1310' is disposed to extend through middle points S-S' of segments, each of which connects to two lower actuators among the three left or right sound generating actuators.

FIG. 17B illustrates a structure in which only one left actuator and only one right actuator are arranged and the reinforcement member 1310 is disposed to extend through centers of the left and right actuators 1210 and 1210'. In this structure, two divided reinforcement members may be formed in consideration of the arrangement structure of the actuators inserted in and supported by the cover bottom.

The symmetric arrangement of two or more sound generating actuators having different vibration characteristics as described above can prevent deformation (twisting) of the cover bottom due to the different vibration characteristics of the sound generating actuators or sound distortion by the vibration of the cover bottom.

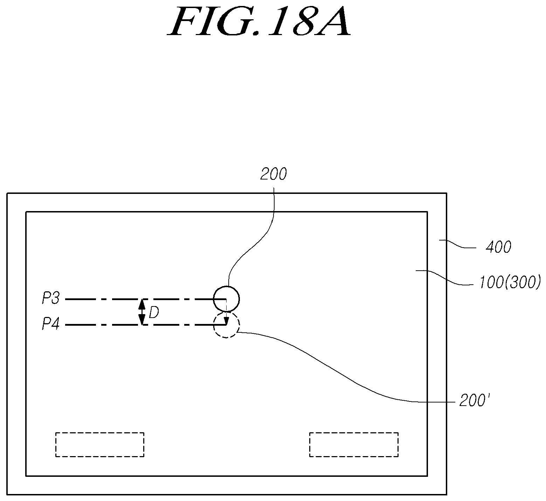

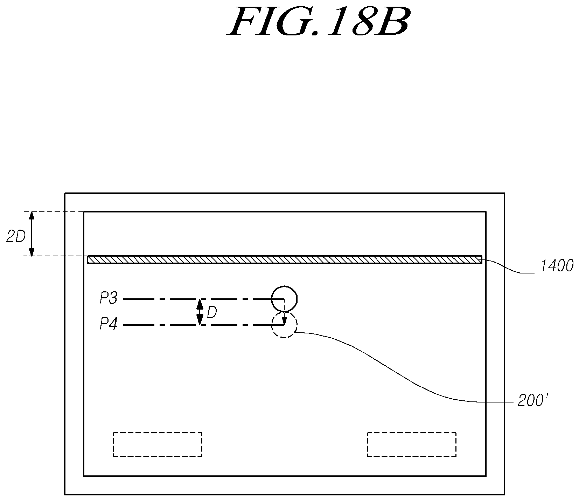

FIGs. 18A and 18B illustrate an embodiment, which further includes a sound compensation member in order to maintain the sound output characteristics when the sound generating actuator has been vertically moved by a reason of design.

FIG. 18A illustrates a state in which a sound generating actuator 200 is disposed at an initial position P3 having an optimal sound output characteristic.

However, the sound generating actuator may have to be moved by a predetermined distance D from the initial position P3 in order to maintain the upper end portion to be slim or by reasons relating to design or arrangement of parts.

In this event, only a simple movement of the sound generating actuator changes the relative position with respect to the baffle part 400 and may thus degrade the sound output characteristics.

Therefore, in such a case, if the sound generating actuator is moved to a destination position P4 spaced a movement distance D apart from the initial position P3, a lengthy sound compensation member 1400 is preferably placed at a position spaced 2D apart from an edge (side) opposite to the moving direction.

That is, as shown in FIG. 18B, when the sound generating actuator is moved downward to a position P4 spaced apart by D from the initial position P3 by a reason relating to design, a sound compensation member 1400 lengthily extending in the horizontal direction is placed at a position spaced apart by 2D from the upper edge of the display panel. The arrangement of a sound compensation member at a position corresponding to twice that of the moving distance D of the sound generating actuator enables the moved actuator to be located in the middle of the changed air gap by the sound compensation member, thereby minimizing the change in the sound generation characteristics according to the movement of the actuator.

The sound compensation member 1400 may be implemented by a double-sided tape disposed between the cover bottom and the display panel.

As described above, when it is necessary to change the position of a sound generating actuator, a sound compensation member may be placed at a position proportional to the moving distance, to maintain the relative position of the actuator in the entire air gap, thereby preventing the sound characteristics from changing according to the movement of the actuator.

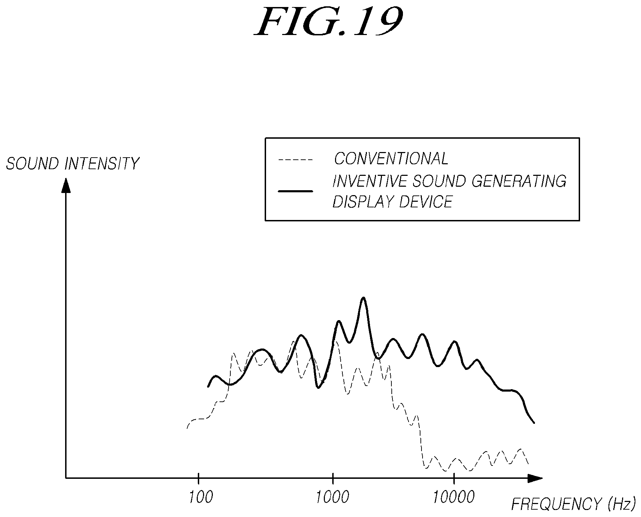

FIG. 19 is a graph illustrating a sound output characteristic in the case of using a panel vibration type sound generating apparatus according to the present embodiment, in comparison with a conventional speaker.

As a result of an actual experiment, a rapid sound intensity reduction (sound pressure reduction) as illustrated by a dotted line in FIG. 19 was observed in the middle/high sound range of 4000 Hz or higher when a speaker disposed at the rear surface or the lower end as shown in FIG. 1 separately from the display panel.

In contrast, as illustrated by a solid line in FIG. 19, the structure according to the present embodiment in which a sound generating actuator is fixed to a support structure to directly vibrate the display panel could reduce the sound pressure reduction in the middle/high sound range, and especially could greatly improve the sound output characteristic in the high sound range.

In result, use of the present embodiment can provide rich sound output in all sound ranges.

According to the present embodiment as described above, one or more sound generating actuators are fixed to a support structure to directly vibrate the display panel. Therefore, the progressing direction of the sound coincides with the image output direction to enhance the sound localization and improve the sound output characteristics in a wide sound range.

Further, since a display device or a set apparatus does not require a separate speaker, the mechanism of the set apparatus can be easily designed and the thickness of the display device or set apparatus can be reduced.

Especially, a predetermined air gap is formed between the display panel and the sound generating actuator and the sound generating actuator is inserted in and fixed to a support hole formed at a support structure of the display device. Therefore, the display device has an excellent sound generation performance while having a reduced thickness.

Further, a baffle part, which includes an adhesive member (double-sided tape) attached between the upper surface of the support structure and the lower surface of the display panel and a sealing part disposed outside the adhesive member, can minimize the sound leakage and thus can improve the sound generating performance.

Further, the arrangement of one or more buffer members between a source PCB of the display panel and the support structure disposed at the rear surface of the display panel to fix/support the sound generating actuator or between the inner surface of the support structure and the rear surface of the display panel adjacent to the source PCB can prevent generation of interference and noise between the support structure of the display device and a source PCB (S-PCB) for driving the display panel.

Also, the arrangement of a reinforcement member on the support structure of the display device when two or more sound generating actuators are used can prevent deformation of the support structure due to different vibrations of the two or more sound generating actuators.

The above description and the accompanying drawings provide an example of the technical idea of the present invention for illustrative purposes only. Those having ordinary knowledge in the technical field, to which the present invention pertains, will appreciate that various modifications and changes in form, such as combination, separation, substitution, and change of a configuration, are possible without departing from the essential features of the present invention. Therefore, the embodiments disclosed in the present invention are intended to illustrate the scope of the technical idea of the present invention, and the scope of the present invention is not limited by the embodiment. The scope of the present invention shall be construed on the basis of the accompanying claims.

## Claims

1. A panel vibration type sound generating display device comprising:
a display panel (100) for displaying an image;
a sound generating actuator (200) connected to a surface of the display panel and configured to vibrate the display panel (100) to generate sound;
a support structure comprising a cover bottom (300) and a middle cabinet (500), wherein an air gap is provided between the cover bottom and the display panel (100), the cover bottom (300) covering and supporting at least a rear surface of the display panel (100);
a baffle part (400) between the middle cabinet (500) and the display panel (100) to surround the air gap, wherein the display panel (100) is sealingly coupled to the cover bottom (300); and
the middle cabinet (500) supporting an edge of the display panel, and comprising an area division member (510) arranged to separate a space between the cover bottom and the display panel into a first area and a second area, the first area including a source printed circuit board "PCB" (700) and the second area including the sound generating actuator (200).

2. The display device of claim 1, wherein the sound generating actuator (200) comprises:
a plate (210) inserted in the support hole;
a magnet (220) disposed on the plate;
a center pole (230) disposed on the plate;
a bobbin (250) surrounding the center pole and connected to the display panel (100); and
a coil (260) wound around the bobbin.

3. The display device of claim 2, wherein the plate (210) includes an extension part (212) connected to an exterior surface of the cover bottom (300).

4. The display device of any preceding claim, further comprising another sound generating actuator (200, 1210, 1210', 1220, 1220') connected to a surface of the display panel (100) and configured to vibrate the display panel (100) to generate sound.

5. The display device of claim 4, wherein the sound generating actuators (200, 1210, 1210', 1220, 1220') are arranged at left and right sides of the display panel and are configured to be differently vibrated such that they are configured to generate stereo sound,
wherein the sound generating actuators (200, 1210, 1210', 1220, 1220') are symmetrically arranged at left and right portions of the display panel.

6. The display device of claim 4 or 5, wherein the sound generating actuators (200, 1210, 1210', 1220, 1220') are configured to vibrate the display panel (100) to generate sound progressing in a direction coinciding with an image output direction of the display panel (100) to localize the output sound.

## Patentansprüche

1. Schallerzeugende Anzeigevorrichtung vom Plattenvibrationstyp, umfassend:
ein Anzeigefeld (100) zum Anzeigen eines Bildes;
einen schallerzeugenden Aktuator (200), der mit einer Oberfläche des Anzeigefelds verbunden und dazu ausgelegt ist, das Anzeigefeld (100) in Schwingung zu versetzen, um Schall zu erzeugen;
eine Tragstruktur, umfassend einen Abdeckungsboden (300) und einen Mittelrahmen (500), wobei ein Luftspalt zwischen dem Abdeckungsboden und dem Anzeigefeld (100) vorgesehen ist, wobei der Abdeckungsboden (300) mindestens eine hintere Oberfläche des Anzeigefelds (100) bedeckt und trägt;
einen Prallwandteil (400) zwischen dem Mittelrahmen (500) und dem Anzeigefeld (100), um den Luftspalt zu umgeben, wobei das Anzeigefeld (100) abdichtend mit dem Abdeckungsboden (300) gekoppelt ist; und
wobei der Mittelrahmen (500) einen Rand des Anzeigefelds trägt und ein Bereichsteilungselement (510) umfasst, dazu angeordnet, einen Raum zwischen dem Abdeckungsboden und dem Anzeigefeld in einen ersten Bereich und einen zweiten Bereich zu trennen, wobei der erste Bereich eine Source-Leiterplatte (PCB) (700) beinhaltet und der zweite Bereich den schallerzeugenden Aktuator (200) beinhaltet.

2. Anzeigevorrichtung nach Anspruch 1, wobei der schallerzeugende Aktuator (200) umfasst:
eine Platte (210), die in das Stützloch eingesetzt ist;
einen Magneten (220), der auf der Platte angeordnet ist;
einen Mittelpol (230), der auf der Platte angeordnet ist;
einen Spulenträger (250), der den Mittelpol umgibt und mit dem Anzeigefeld (100) verbunden ist; und
eine Spule (260), die um die Spulenträger gewickelt ist.

3. Anzeigevorrichtung nach Anspruch 2, wobei die Platte (210) einen Verlängerungsteil (212) beinhaltet, der mit einer Außenoberfläche des Abdeckungsbodens (300) verbunden ist.

4. Anzeigevorrichtung nach einem der vorhergehenden Ansprüche, ferner umfassend einen weiteren schallerzeugenden Aktuator (200, 1210, 1210', 1220, 1220'), der mit einer Oberfläche des Anzeigefelds (100) verbunden und dazu ausgelegt ist, das Anzeigefeld (100) in Schwingung zu versetzen, um Schall zu erzeugen.

5. Anzeigevorrichtung nach Anspruch 4, wobei die schallerzeugenden Aktuatoren (200, 1210, 1210', 1220, 1220') an der linken und rechten Seite des Anzeigefelds angeordnet sind und dazu ausgelegt sind, unterschiedlich in Schwingung versetzt zu werden, sodass sie dazu ausgelegt sind, Stereoschall zu erzeugen,
wobei die schallerzeugenden Aktuatoren (200, 1210, 1210', 1220, 1220') symmetrisch an einem linken und einem rechten Abschnitt des Anzeigefelds angeordnet sind.

6. Anzeigevorrichtung nach Anspruch 4 oder 5, wobei die schallerzeugenden Aktuatoren (200, 1210, 1210', 1220, 1220') dazu ausgelegt sind, das Anzeigefeld (100) in Schwingung zu versetzen, um Schall zu erzeugen, der in einer Richtung fortschreitet, die mit einer Bildausgaberichtung des Anzeigefelds (100) zusammenfällt, um den ausgegebenen Schall zu lokalisieren.

## Revendications

1. Dispositif d'affichage à génération de son de type à vibration d'écran, comprenant :
un écran d'affichage (100) destiné à afficher une image ;
un actionneur de génération de son (200) raccordé à une surface de l'écran d'affichage et configuré pour faire vibrer l'écran d'affichage (100) pour générer un son ;
une structure de support comprenant un fond-couvercle (300) et une enceinte médiane (500), dans lequel un intervalle d'air est prévu entre le fond-couvercle et l'écran d'affichage (100), le fond-couvercle (300) couvrant et supportant au moins une surface arrière de l'écran d'affichage (100) ;
une partie diffuseur acoustique (400) entre l'enceinte médiane (500) et l'écran d'affichage (100) pour entourer l'intervalle d'air, dans lequel l'écran d'affichage (100) est couplé de façon étanche au fond-couvercle (300) ; et
l'enceinte médiane (500) supportant un bord de l'écran d'affichage, et comprenant un élément de division de zone (510) agencé pour séparer un espace entre le fond-couvercle et l'écran d'affichage en une première zone et une seconde zone, la première zone incluant une carte de circuit imprimé, Printed Circuit Board « PCB », source (700) et la seconde zone incluant l'actionneur de génération de son (200).

2. Dispositif d'affichage de la revendication 1, dans lequel l'actionneur de génération de son (200) comprend :
une plaque (210) insérée dans le trou de support ;
un aimant (220) disposé sur la plaque ;
une colonne centrale (230) disposée sur la plaque ;
une bobine (250) entourant la colonne centrale et raccordée à l'écran d'affichage (100) ; et
un enroulement (260) enroulé autour de la bobine.

3. Dispositif d'affichage de la revendication 2, dans lequel la plaque (210) inclut une partie d'extension (212) raccordée à une surface extérieure du fond-couvercle (300).

4. Dispositif d'affichage d'une quelconque revendication précédente, comprenant en outre un autre actionneur de génération de son (200, 1210, 1210', 1220, 1220') raccordé à une surface de l'écran d'affichage (100) et configuré pour faire vibrer l'écran d'affichage (100) pour générer un son.

5. Dispositif d'affichage de la revendication 4, dans lequel les actionneurs de génération de son (200, 1210, 1210', 1220, 1220') sont agencés sur des côtés gauche et droit de l'écran d'affichage et sont configurés pour vibrer différemment de manière telle qu'ils sont configurés pour générer un son stéréo,
dans lequel les actionneurs de génération de son (200, 1210, 1210', 1220, 1220') sont agencés symétriquement dans des portions gauche et droite de l'écran d'affichage.

6. Dispositif d'affichage de la revendication 4 ou 5, dans lequel les actionneurs de génération de son (200, 1210, 1210', 1220, 1220') sont configurés pour faire vibrer l'écran d'affichage (100) pour générer un son progressant dans une direction coïncidant avec une direction de sortie d'image de l'écran d'affichage (100) pour localiser le son de sortie.
